# EUROPEAN PATENT SPECIFICATION

(11) **EP 3 189 929 B1**
(45) Date of publication and mention of the grant of the patent: **14.08.2019**
(21) Application number: 15837355.5
(22) Date of filing: 04.09.2015
(51) Int. Cl.: B23K 35/26, C22C 13/00, H01F 27/28, H05K 3/34

(54) **LEAD-FREE SOLDER ALLOY FOR USE IN TERMINAL PREPLATING, AND ELECTRONIC COMPONENT**
BLEIFREIE LÖTLEGIERUNG ZUR ANSCHLUSSPLATTIERUNG UND ELEKTRONISCHE KOMPONENTE
ALLIAGE DE SOUDURE SANS PLOMB POUR L'UTILISATION AU PRÉ-PLACAGE DE BORNES, ET COMPOSANT ÉLECTRONIQUE

(30) Priority: 04.09.2014 JP 2014180369
(43) Date of publication of application: 12.07.2017
(73) Proprietor: SENJU METAL INDUSTRY CO., LTD., Tokyo 120-8555 (JP)
(72) Inventor: YOSHIKAWA Shunsaku, Tokyo 120-8555 (JP)
(74) Representative: Zimmermann & Partner Patentanwälte mbB
(86) International application number: PCT/JP2015/075179
(87) International publication number: WO 2016/035879

(56) References cited:
- WO-A1-2009/022758
- CN-A- 103 406 687
- CN-A- 103 406 687
- JP-A- H1 192 997
- JP-A- 2003 001 482
- JP-A- 2004 154 864
- JP-A- 2004 181 485
- JP-A- 2008 221 341
- US-A1- 2004 115 088

## Description

### [TECHNICAL FIELD]

The present invention relates to a lead-free solder alloy, particularly, a lead-free solder alloy for terminal preliminary plating, which is suitable for soldering or preliminarily plating terminals of a coil, and an electronic component.

### [BACKGROUND]

In the electronic component, a coil component like a transformer in which a copper fine wire is wound around a lead part is used. A component in which a coil is wound is also used for a motor of a disk drive, a cooling fan or the like in a computer. In these coils, their terminals of coil are soldered to terminal posts of an electronic component or a motor in order to conduct them.

In general, since a surface of copper wire used in the coil component is enameled and polyurethane resin is also covered thereon, it is impossible to solder the terminals of the coil with the terminal posts if the copper wire is remained as it is. When soldering it, the enamel and the polyurethane resin (hereinafter, referred to as "coating materials") are required to be removed from the terminals of the coil. Although it is conceivable that a cutting tool is used to mechanically remove the coating materials, such a mechanical removal thereof takes time, which causes poor productivity. Accordingly, as the removal of the coating materials from the terminals of the coil, a method of removing the coating materials by heating and melting them has been taken. The method of removing the coating materials by heating them is referred to as one to remove the coating materials by dipping the terminals of the coil into molten solder to melt them with heat of the molten solder.

By the way, when soldering the terminals of the coil to the terminal posts, preliminary plating has been performed on the terminals of the coil in advance in order to obtain excellent soldered portions. The preliminary plating on the terminals of the coil has been generally carried out by dipping the terminals of the coil into the molten solder. Since the terminals of the coil have been also dipped into the molten solder in the above-mentioned removal of the coating materials, a reasonable operation is realized such that the dipping of the terminals of the coil into the molten solder allows the preliminary plating to be carried out at the same time of the removal of the coating materials.

In the removal of the coating materials from the terminals of the coil and the preliminary plating, flux is applied to the terminals of the coil and then, the terminals are dipped into the molten solder. So, by heat of the molten solder, the coating materials are melted and the flux applied to the terminals of the coil rises around the dipped terminals of the coil. Therefore, the flux acts on a part of the copper wire stripped by removal of the coating materials, so that the molten solder is metallically joined to the coper wire.

As the preliminary plating of the terminals of the coil, Pb-Sn solder has been used up to now but use of the Pb-Sn solder has been limited because of lead pollution. In recent years, lead-free solder excluding Pb has been used. In a case of soldering the terminals of the coil, in order to melt and remove the coating materials, it is required that the molten solder is heated up to temperature of around 400 degrees C so that soldering temperature thereof becomes around 400 degrees C. When, however, the soldering temperature is set so as to be higher in the lead-free solder, an oxidation advances at a surface of the molten solder to generate a large amount of oxides. The generation of the large amount of oxides causes a lot of them to be adhered to the soldered portion, thereby deteriorating appearance of products and wettability thereof to fail to get an excellent soldered portion.

A technology in which P or Ga is added to a Sn-Cu-Ni based lead-free solder alloy has been known (see, for example, Patent Document 1).

It has been known that the addition of P or Ga shows oxidation inhibitory effect. As a countermeasure for inhibiting oxides, a technology has been disclosed such that, by adding P and Ga into a Sn-Cu-Ni based solder alloy, oxidation resistance is improved in the surface of the molten solder (see, for example, Patent Document 2).

Further, a technology has been disclosed such that, by adding P or Ge or P and Ge into a solder alloy having a principal ingredient of Sn, to which Ga has been added, oxidation inhibitory effect is attained at around 400 degrees C (see, for example, Patent Document 3 or 4).

In addition, a technology has been disclosed such that, by adding P or Ge into a Sn-Cu-Ni based solder alloy, oxide film formation is inhibited (see, for example, Patent Document 5).

A technology has been also disclosed such that, by adding Ga as lead-free additive alloy to be added into molten solder having a principal ingredient of Sn, appearance of the solder surface is improved (see, for example, Patent Document 6).

### [DOCUMENT FOR PRIOR ART]

### [PATENT DOCUMENTS]

Patent Document 1: W2007/082459 (see Embodiments)
Patent Document 2: CN103406687A (see Tables 1 and 3, paragraphs [0071] and [0072])
Patent Document 3: Japanese Patent Application Publication No.2008-221341 (see Table 1, paragraph [0022])
Patent Document 4: Japanese Patent Application Publication No.2004-181485 (see Table 1, paragraph [0025])
Patent Document 5: Japanese Patent Application Publication No.2001-334384 (see column of Effect of the Invention)
Patent Document 6: Japanese Patent Application Publication No. H11-333589 (see paragraph [0015])

### [SUMMARY OF THE INVENTION]

### [PROBLEMS TO BE SOLVED BY THE INVENTION]

In a case of carrying out the preliminary plating by solder on the terminals of the coil or the like, it is required to inhibit a phenomenon of so-called "bridge" in which the terminals are connected to each other by the solder from generating, when pulling up the terminals from the molten solder, and/or to inhibit solder icicle from generating. Particularly, when setting the soldering temperature to be around 400 degrees C to remove the coating materials, a solder alloy having excellent separation property is required. In the Patent Documents 1 through 6, a technology in which P and/or Ga are added, in order to improve the separation property in the solder, when setting the soldering temperature to be around 400 degrees C, has been not described. They have not described any effect such that the addition of P and/or Ga allows inhibiting the bridge and the solder icicle from generating.

Accordingly, the present invention has an object of providing a lead-free solder alloy for terminal preliminary plating, the separation property of which is improved in a use condition when the soldering temperature is set to be around 400 degrees C, and an electronic component.

The invention is defined in the claims.

### [MEANS FOR SOLVING THE PROBLEMS]

The inventor of the present application have found out that in a Sn-Cu-Ni based lead-free solder alloy having a principle ingredient of Sn in which additive amounts of Cu and Ni are set so that the soldering temperature is around 400 degrees C, the separation property thereof is improved, even if the soldering temperature is around 400 degrees C, by adding predetermined amounts of Ga and P, and he accomplishes this invention.

The invention claimed in Claim 1 relates to a lead-free solder alloy for terminal preliminary plating, by which preliminary plating is performed on a terminal by dipping, the alloy containing 4 mass % or more and 6 mass % or less of Cu, more than 0.1 mass % and less than 0.2 mass % of Ni, 0.01 mass % or more and 0.04 mass % or less of Ga, 0.004 mass % or more and 0.03 mass % or less of P, and a remainder of Sn, a total amount of Ga and P being 0.05 mass % or less, wherein surface tension of the lead-free solder alloy upon pulling up a platinum ring having circumference of 4 cm from the lead-free solder alloy which is_in a melted condition by heating at 400 degrees C is 200 mN/m or less (200 dyn/cm or less).

### [EFFECTS OF THE INVENTION]

By having a principle ingredient of Sn and containing 4 mass % or more and 6 mass % or less of Cu and more than 0.1 mass % and less than 0.2 mass % of Ni, it has a composition which is suitable for setting the soldering temperature to be around 400 degrees C. By containing 0.01 mass % or more and 0.04 mass % or less of Ga, 0.004 mass % or more and 0.03 mass % or less of P, a total amount of Ga and P being 0.05 mass % or less, wherein tension of the lead-free solder alloy upon pulling up a platinum ring having circumference of 4 cm from the lead-free solder alloy which is in a melted condition by heating at 400 degrees C is 200 mN/m or less (200 dyn/cm or less), separation property is improved when pulling up an object to be preliminarily plated such as the terminal posts of the coil from the molten solder even if the soldering temperature at terminal preliminary plating time is around 400 degrees C. In an electronic component, terminal posts of which are preliminarily plated by dipping and pulling up the terminal posts into and from the molten solder using the lead-free solder alloy for terminal preliminary plating according to this invention, the separation property of the solder at the terminal preliminary plating time is improved, thereby allowing inhibiting the bridge and the solder icicle from generating.

### [BRIEF DESCRIPTION OF DRAWINGS]

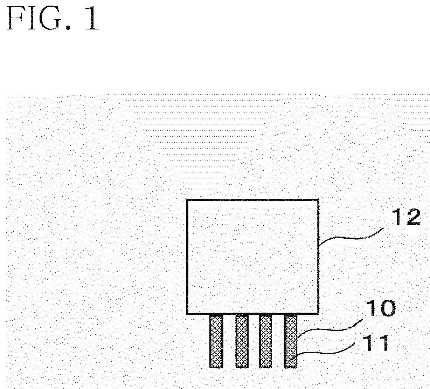

FIG. 1 is a diagram illustrating one configuration example of an electronic component according to the embodiment.

### [PREFARRED EMBODIMENT FOR CARRYING OUT THE INVENTION]

When adding predetermined amounts of Ga and P into a solder alloy having a principle ingredient of Sn, melt viscosity of a surface of the solder is reduced, so that tension of the solder is also reduced when pulling up an object to be soldered, for example, the terminals of the coil from the molten solder. This allows the separation property of the solder to be improved when pulling up the terminals thereof from the molten solder, thereby enabling the generation of the bridge and/or the solder icicle to be inhibited.

When adding small amounts of Ga and P, tension of the solder remains high when pulling up the terminals thereof from the molten solder. This fails to get sufficient effect of improving the separation property. As described above, when removing the enamel or the polyurethane resin as the coating materials of the coil by dipping the terminals of the coil into the molten solder, it is required to heat the molten solder to temperature of around 400 degrees C to make the soldering temperature around 400 degrees C.

The temperature in a case of dipping the object to be soldered into the molten solder and soldering it is generally 20 through 50 degrees C over the melting point of the solder due to heat capacity of the terminals of an object to be processed or a part such as the coil having the terminals. When, however, the soldering temperature exceeds 470 degrees C, the coated materials are carbonized in a moment in dipping the terminals of the coil into the molten solder, so that they are adhered to the terminals. This prevents the metal joining of the solder. Accordingly, it is preferable that a solder alloy used for the preliminary plating of the terminals is a solder alloy having a melting point of the solder of 420 degrees C or less so that the soldering temperature thereof is 470 degrees C or less. Further, when the soldering temperature thereof exceeds 470 degrees C, copper leaching becomes remarkable.

On the other hand, when additive amounts of Ga and P are increased more than necessary, the melting point of the solder is also increased in height, which is unavailable for soldering at around 400 degrees C.

When adding only either Ga or P into the solder alloy having a principle ingredient of Sn, it is possible to get oxidation inhibitory effect but it is impossible to obtain a sufficient effect to improve the separation property.

By taking into consideration an additive amount of Ga in a case of adding both of Ga and P into the solder alloy having a principle ingredient of Sn, it is impossible to obtain a sufficient effect to improve the separation property when the additive amount of Ga is less than 0.01 mass %. On the other hand, when the additive amount of Ga exceeds 0.04 mass %, the melting point of the solder is increased in height, which is unavailable for soldering at around 400 degrees C.

By taking into consideration an additive amount of P in a case of adding both of Ga and P into the solder alloy having a principle ingredient of Sn, it is impossible to obtain a sufficient effect to improve the separation property when the additive amount of P is less than 0.004 mass %. On the other hand, when the additive amount of P exceeds 0.03 mass %, the melting point of the solder is increased in height, which is unavailable for soldering at around 400 degrees C.

Provided that when Ga and P are respectively added to almost their upper limit values, the melting point of the solder is also increased in height, which is unavailable for soldering at around 400 degrees C.

Therefore, within a range where a total additive amount of Ga and P is 0.05 mass % or less, 0.01 mass % or more and 0.04 mass % or less of Ga and 0.004 mass % or more and 0.03 mass % or less of P are added.

When an additive amount of Cu having copper leaching prevent effect is less than 4 mass % in the solder alloy having a principle ingredient of Sn, the copper leaching prevent effect does not appear. On the other hand, when an additive amount of Cu exceeds 6 mass %, the melting point of the solder is increased in height.

Additionally, when adding Ni to the above-mentioned solder alloy having a principle ingredient of Sn in which the additive amount of Cu is 4 through 6 mass %, the copper leaching prevent effect thereof is enhanced in the soldering at around 400 degrees C. When, however, the additive amount of Ni is less than 0.1 mass %, the copper leaching prevent effect thereof is not enhanced. On the other hand, when the additive amount of Ni exceeds 0.2 mass %, the melting point of the solder is also increased in height.

It is known that when adding Ag into the solder alloy having a principle ingredient of Sn, the wettability thereof is improved. The addition of expensive Ag causes product costs to rise, which is not preferable. According to this invention, even when no Ag is added, the separation property of the solder is improved when pulling up the terminals from the molten solder.

### [EXECUTED EXAMPLES]

Executed examples and comparison examples will be indicated in Table 1. It is to be noted that an additive amount of each element is indicated in the Table 1 as mass %.

Executed examples 9 and 10 in table 1 are reference examples.

### TABLE 1

**Table 1**

| | Sn | Cu | Ni | P | Ga | P+Ga | EVALUATION OF DRIBBLE PROPERTY AND SOLDER ICICLE/BRIDGE | | |
|---|---|---|---|---|---|---|---|---|---|
| | | | | | | | TENSION OF SOLDER | NUMBER OF GENERATED SOLDER ICICLE/BRIDGE | RESULT |
| EXECUTED EXAMPLE 1 | bal. | 5 | 0,15 | 0,015 | 0,02 | 0,035 | 127 | 0 | ○ |
| EXECUTED EXAMPLE 2 | bal. | 5 | 0,15 | 0,03 | 0,02 | 0,05 | 128 | 0 | ○ |
| EXECUTED EXAMPLE 3 | bal. | 5 | 0,15 | 0,004 | 0,04 | 0,044 | 127 | 0 | ○ |
| EXECUTED EXAMPLE 4 | bal. | 5 | 0,15 | 0,004 | 0,02 | 0,024 | 135 | 0 | ○ |
| EXECUTED EXAMPLE 5 | bal. | 5 | 0,15 | 0,015 | 0,01 | 0,025 | 128 | 0 | ○ |
| EXECUTED EXAMPLE 6 | bal. | 5 | 0,15 | 0,004 | 0,01 | 0,014 | 128 | 0 | ○ |
| EXECUTED EXAMPLE 7 | bal. | 6 | 0,15 | 0,015 | 0,02 | 0,035 | 130 | 1 | ○ |
| EXECUTED EXAMPLE 8 | bal. | 4 | 0,15 | 0,015 | 0,02 | 0,035 | 120 | 0 | ○ |
| EXECUTED EXAMPLE 9 | bal. | 5 | 0,2 | 0,015 | 0,02 | 0,035 | 133 | 0 | ○ |
| EXECUTED EXAMPLE 10 | bal. | 5 | 0,1 | 0,015 | 0,02 | 0,035 | 118 | 0 | ○ |
| COMPARISON EXAMPLE 1 | bal. | 5 | 0,15 | - | - | 0 | 400 | 33 | × |
| COMPARISON EXAMPLE 2 | bal. | 5 | 0,15 | 0,015 | - | 0,015 | 294 | 15 | × |
| COMPARISON EXAMPLE 3 | bal. | 5 | 0,15 | - | 0,02 | 0,02 | 307 | 17 | × |
| COMPARISON EXAMPLE 4 | bal. | 5 | 0,15 | 0,05 | 0,02 | 0,07 | - | - | - |
| COMPARISON EXAMPLE 5 | bal. | 5 | 0,15 | 0,015 | 0,06 | 0,075 | - | - | - |
| COMPARISON EXAMPLE 6 | bal. | 5 | 0,15 | 0,001 | 0,02 | 0,021 | 305 | 14 | × |
| COMPARISON EXAMPLE 7 | bal. | 5 | 0,15 | 0,015 | 0,001 | 0,016 | 292 | 14 | × |
| COMPARISON EXAMPLE 8 | bal. | 5 | 0,15 | 0,001 | 0,008 | 0,009 | 385 | 29 | × |
| COMPARISON EXAMPLE 9 | bal. | 5 | 0,15 | 0,02 | 0,04 | 0,06 | - | - | - |
| COMPARISON EXAMPLE 10 | bal. | 7 | 0,15 | 0,015 | 0,02 | 0,035 | - | - | - |
| COMPARISON EXAMPLE 11 | bal. | 5 | 0,3 | 0,015 | 0,02 | 0,035 | - | - | - |

In evaluation of separation property of the solder shown in TABLE 1, tension when pulling up a specimen from the molten solder was evaluated. As a method of evaluating the tension, a ring method using a surface tension balance of Du Noϋy was adopted. After respective solder materials having compositions shown in the executed examples and the comparison examples were melted at 400 degrees C using a solder bath, the molten solder surface was scraped and immobile for five minutes. Then, a platinum ring (specimen) having circumference of 4 cm, fat of which had been previously removed by IPA, was dipped thereinto and tension when pulling up it was measured unit dyn/cm (mN/m). Ten measurements were carried out for each solder composition and an average value thereof was calculated as the tension.

In the evaluation of the solder icicle and the bridge, after respective solder materials having compositions shown in the executed examples and the comparison examples were melted at 400 degrees C, the molten solder surface was scraped. The terminals of the coil to which the flux had been previously applied were dipped thereinto and number of generated solder icicle and bridge was evaluated when pulling up them. The terminals of the coil were four terminals on each side and Cu wire coil having a pitch of 2 mm was used. As the flux, rosin-based post flux (SR-209 made by Senju Metal Industrial Company) was used. A total of 20 coils was used to measure a total number of generated solder icicle and bridge. A dipping condition was set to be a dipping rate of 10 mm/sec, a dipping depth of 4 mm and a pulling-up rate of 10 mm/sec.

When the tension in the separation property of the solder was 200 mN/m or less (200 dyn/cm or less) or less and the total number of generated solder icicle and bridge was 5 or less, the evaluation result was indicated as O. When the tension in the separation property of the solder exceeded 200 mN/m (200 dyn/cm) and the total number of generated solder icicle and bridge exceeded 5, the evaluation result was indicated as X.

As shown in each executed example shown in the Table 1, into a solder alloy having a principle ingredient of Sn and containing 4 mass % or more and 6 mass % or less of Cu and more than 0.1 mass % and less than 0.2 mass % of Ni, by adding 0.01 mass % or more and 0.04 mass % or less of Ga and 0.004 mass % or more and 0.03 mass % or less of P within a range in which a total amount of Ga and P is 0.05 mass % or less, it has been found that the separation property of the solder upon pulling up the terminals from the molten solder is improved, thereby inhibiting the solder icicle and the bridge from generating.

For example, in the executed example 1 in which 0.02 mass % of Ga that is the lower limit value or more and the upper limit value or less and 0.015 mass % of P that is the lower limit value or more and the upper limit value or less are added within a range in which a total amount of Ga and P is 0.05 mass % or less, it has been found that the separation property of the solder upon pulling up the terminals from the molten solder is improved, thereby inhibiting the solder icicle and the bridge from generating.

Further, even in the executed example 2 in which 0.03 mass % of P that is the upper limit value is added and 0.02 mass % of Ga is added to be included within a range in which a total amount of Ga and P is 0.05 mass % or less and even in the executed example 3 in which 0.04 mass % of Ga that is the upper limit value is added and 0.004 mass % of P is added to be included within a range in which a total amount of Ga and P is 0.05 mass % or less, it has been found that the separation property of the solder when pulling up the terminals from the molten solder is improved, thereby inhibiting the solder icicle and the bridge from generating.

Additionally, in the executed example 4 in which 0.004 mass % of P that is the lower limit value is added, when adding 0.02 mass % of Ga that is less than the upper limit value, it has been found that the separation property of the solder when pulling up the terminals from the molten solder is improved, thereby inhibiting the solder icicle and the bridge from generating.

In the executed example 5 in which 0.01 mass % of Ga that is the lower limit value is added, when adding 0.015 mass % of P that is less than the upper limit value, it has been found that the separation property of the solder when pulling up the terminals from the molten solder is improved, thereby inhibiting the solder icicle and the bridge from generating.

In the executed example 6 in which 0.004 mass % of P that is the lower limit value is added and 0.01 mass % of Ga that is the lower limit value is added, it has been found that the separation property of the solder when pulling up the terminals from the molten solder is improved, thereby inhibiting the solder icicle and the bridge from generating.

In the executed example 7 in which the same values of Ga and P as those of the executed example 1 are added and Cu of the upper limit value is added and in the executed example 8 in which Cu of the lower limit value is added, it has been found that this does not exert any influence upon the separation property by the addition of Ga and P.

In the executed example 9 in which the same values of Ga and P as those of the executed example 1 are added and Ni higher than the claimed upper limit is added and in the executed example 10 in which Ni lower than the claimed lower limit is added, it has been found that this does not exert any influence upon the separation property by the addition of Ga and P.

On the other hand, in the comparison example 1 in which a solder alloy has a principle ingredient of Sn and contains 4 mass % or more and 6 mass % or less of Cu and more than 0.1 mass % and less than 0.2 mass % of Ni but does not contain Ga and P, it has been found that the separation property of the solder when pulling up the terminals from the molten solder is poor, so that a generation of the solder icicle and the bridge cannot be inhibited.

In the comparison examples 2 and 3 in which any one of Ga and P is added to a solder alloy having a principle ingredient of Sn, it has been also found that the separation property of the solder when pulling up the terminals from the molten solder is poor, so that a generation of the solder icicle and the bridge cannot be inhibited.

Further, in the comparison example 4 in which both of Ga and P are added to a solder alloy having a principle ingredient of Sn but P exceeding the upper limit value is added and in the comparison example 5 in which Ga exceeding the upper limit value is added, the melting point exceeds +20 degrees C from the melting point of the executed example 1, so that the sufficient solderability at around 400 degrees C could not be obtained. Therefore, the evaluation of the separation property of the solder and the solder icicle and the bridge has not been performed.

In the comparison example 6 in which both of Ga and P are added to a solder alloy having a principle ingredient of Sn but P less than the lower limit value is added, in the comparison example 7 in which Ga less than the lower limit value is added, and in the comparison example 8 in which Ga and P which are both less than the lower limit value are added, it has been found that the separation property of the solder when pulling up the terminals from the molten solder is poor, so that a generation of the solder icicle and the bridge cannot be inhibited.

In the comparison example 9 in which both of Ga and P are added to a solder alloy having a principle ingredient of Sn but a total amount of Ga and P exceeding the upper limit value is added, the melting point exceeds +20 degrees C from the melting point of the executed example 1, so that the sufficient solderability at around 400 degrees C could not be obtained. Therefore, the evaluation of the separation property of the solder and the solder icicle and the bridge has not been performed.

In the comparison example 10 in which the same values of Ga and P as those of the executed example 1 are added and Cu exceeding the upper limit value is added and in the comparison example 11 in which Ni exceeding the upper limit value is added, the melting point exceeded +20 degrees C from the melting point of the executed example 1, so that the sufficient solderability at around 400 degrees C could not be obtained. Therefore, the evaluation of the separation property of the solder and the solder icicle and the bridge has not been performed.

From the above results, as shown in FIG. 1, in an electronic component 12, the terminals 10 of which are preliminarily plated with the solder 11 by dipping the terminals 10 into the molten solder at around 400 degrees C and pulling up them using the lead-free solder alloy for terminal preliminary plating according to this invention, it is possible to melt the coating materials by heat of the molten solder to remove them, and it has been found that the separation property of the solder when the soldering is carried out at around 400 degrees C is improved, thereby inhibiting the solder icicle and the bridge from generating.

In addition, the temperature of around 400 degrees C at the soldering is referred to as a range of temperature between 380 degrees C and 470 degrees C. This is because the temperature of the molten solder must be 380 degrees C or more in order to remove the coating materials but the soldering must be carried out with the temperature of the molten solder being 470 degrees C or less to prevent the coating materials from being carbonized. Further, the solder alloy having a melting point of 420 degrees C or less is preferable so that the soldering temperature thereof is 470 degrees C or less.

### DESCRIPTION OF CODES

10...Terminals; 11....Solder; and 12....Electronic Component

## Claims

1. A lead-free solder alloy for terminal preliminary plating, by which preliminary plating is performed on a terminal by dipping, the alloy comprising:
4 mass % or more and 6 mass % or less of Cu;
more than 0.1 mass % and less than 0.2 mass % of Ni;
0.01 mass % or more and 0.04 mass % or less of Ga;
0.004 mass % or more and 0.03 mass % or less of P; and
a remainder of Sn, a total amount of Ga and P being 0.05 mass % or less, wherein surface tension of the lead-free solder alloy upon pulling up a platinum ring having a circumference of 4 cm from the lead-free solder alloy which is in a melted condition by heating at 400 degrees C is 200 mN/m or less (200 dyn/cm or less).

2. Use of the lead-free solder alloy according to Claim 1 for terminal preliminary plating in which the soldering temperature is between 380 degrees C and 470 degrees C.

3. An electronic component in which preliminary plating is performed on a terminal by using the lead-free solder alloy for terminal preliminary plating according to Claim 1 or 2.

## Patentansprüche

1. Bleifreie Lötlegierung zur Anschlussvorplattierung, mittels derer eine Vorplattierung an einem Anschluss durch Tauchen erfolgt, wobei die Legierung umfasst:
4 Masse-% oder mehr und 6 Masse-% oder weniger an Cu;
mehr als 0,1 Masse-% und weniger als 0,2 Masse-% an Ni;
0,01 Masse-% oder mehr und 0,04 Masse-% oder weniger an Ga;
0,004 Masse-% oder mehr und 0,03 Masse-% oder weniger an P; und
einen Rest an Sn, wobei eine Gesamtmenge an Ga und P 0,05 Masse-% oder weniger beträgt, wobei eine Oberflächenspannung der bleifreien Lötlegierung beim Aufziehen eines Platinrings mit einem Umfang von 4 cm ausgehend von der bleifreien Lötlegierung, die sich in einem geschmolzenen Zustand durch Erwärmen bei 400 Grad °C befindet, 200 mN/m oder weniger (200 dyn/cm oder weniger) beträgt.

2. Verwendung der bleifreien Lötlegierung nach Anspruch 1 zur Anschlussvorplattierung, bei der die Löttemperatur zwischen 380 Grad °C und 470 Grad °C liegt.

3. Elektronisches Bauteil, bei dem eine Vorplattierung an einem Anschluss unter Verwendung der bleifreien Lötlegierung zur Anschlussvorplattierung nach Anspruch 1 oder 2 erfolgt.

## Revendications

1. Alliage de soudure sans plomb pour placage préliminaire de borne, au moyen duquel un placage préliminaire est effectué sur une borne par trempage, l'alliage comprenant :
4 % en masse ou plus et 6 % en masse ou moins de Cu ;
plus de 0,1 % en masse et moins de 0,2 % en masse de Ni ;
0,01 % en masse ou plus et 0,04 % en masse ou moins de Ga ;
0,004 % en masse ou plus et 0,03 % en masse ou moins de P ; et
un reste de Sn, une quantité totale de Ga et de P étant de 0,05 % en masse ou moins, sachant qu'une tension de surface de l'alliage de soudure sans plomb lors de la remontée d'un anneau de platine ayant une circonférence de 4 cm depuis l'alliage de soudure sans plomb qui est dans un état fondu par chauffage à 400 degrés C est de 200 mN/n ou moins (200 dyn/cm ou moins).

2. Utilisation de l'alliage de soudure sans plomb selon la revendication 1 pour placage de préliminaire de borne, dans laquelle la température de soudure est comprise entre 380 degrés C et 470 degrés C.

3. Composant électronique dans lequel un placage préliminaire est effectué sur une borne au moyen de l'alliage de soudure sans plomb pour placage préliminaire de borne selon la revendication 1 ou 2.
